# EUROPÄISCHE PATENTSCHRIFT

(11) **EP 1 145 424 B1**
(45) Veröffentlichungstag und Bekanntmachung des Hinweises auf die Patenterteilung: **08.10.2003**
(21) Anmeldenummer: 00907426.1
(22) Anmeldetag: 13.01.2000
(51) Int. Cl.: H03F 1/22

(54) **HYBRID-LEISTUNGS-MOSFET FÜR HOHE STROMTRAGFÄHIGKEIT**
HYBRID POWER MOSFET FOR HIGH CURRENT CARRYING CAPACITY
MOSFET DE PUISSANCE HYBRIDE DESTINE A UNE INTENSITE DE COURANT ADMISSIBLE ELEVEE

(30) Priorität: 22.01.1999 DE 19902519
(43) Veröffentlichungstag der Anmeldung: 17.10.2001
(73) Patentinhaber: SIEMENS AKTIENGESELLSCHAFT, 80333 München (DE)
(72) Erfinder: BAUDELOT, Eric, D-91085 Weisendorf (DE); BRUCKMANN, Manfred, D-90475 Nürnberg (DE); MITLEHNER, Heinz, D-91080 Uttenreuth (DE); WEIS, Benno, D-91334 Hemhofen (DE)
(86) Internationale Anmeldenummer: DE0000119
(87) Internationale Veröffentlichungsnummer: WO00044088

(56) Entgegenhaltungen:
- EP-A- 0 130 082
- MURAGUCHI M ET AL: "A NOVEL MMIC POWER AMPLIFIER FOR POCKET-SIZE CELLULAR TELEPHONES" IEEE MTS INTERNATIONAL MICROWAVE SYMPOSIUM DIGEST,US,NEW YORK, IEEE, Bd. -, 1993, Seiten 793-796, XP000630530
- MCGRATH F ET AL: "A 1.9-GHZ GAAS CHIP SET FOR THE PERSONAL HANDYPHONE SYSTEM" IEEE TRANSACTIONS ON MICROWAVE THEORY AND TECHNIQUES,US,IEEE INC. NEW YORK, Bd. 43, Nr. 7, PART 02, 1. Juli 1995 (1995-07-01), Seiten 1733-1744, XP000514158 ISSN: 0018-9480

## Beschreibung

Die Erfindung bezieht sich auf einen Hybrid-Leistungs-MOSFET gemäß Oberbegriff des Anspruchs 1.

Ein Hybrid-Leistungs-MOSFET mit einem niedersperrenden MOSFET und einem hochsperrenden Sperrschicht-FET ist aus der DE 196 10 135 C bekannt. Anhand der FIG 1 wird dieser bekannte Hybrid-Leistungs-MOSFET näher beschrieben:

Dieser Hybrid-Leistungs-MOSFET weist einen selbstsperrenden n-Kanal-MOSFET 2, insbesondere einen Niedervolt-Leistungs-MOSFET, und einen selbstleitenden n-Kanal-Sperrschicht-FET 4 auf. Dieser hochsperrende Sperrschicht-FET 4 wird auch als **J**unction-**F**ield-**E**ffect-**T**ransistor (JFET) bezeichnet. Diese beiden FET sind derart elektrisch in Reihe geschaltet, daß der Source-Anschluß S des Sperrschicht-FET 4 mit dem Drain-Anschluß D' des MOSFET 2 und daß der Gate-Anschluß G des Sperrschicht-FET 4 mit dem Source-Anschluß S' des MOSFET 2 elektrisch leitend verbunden sind. Diese elektrische Zusammenschaltung zweier Halbleiterbauelemente wird bekanntlich auch als Kaskodenschaltung bezeichnet. Der niedersperrende MOSFET 2 dieser Kaskodenschaltung weist eine interne bipolare Diode D_{IN} auf, die antiparallel zum MOSFET 2 geschaltet ist und allgemein als Inversdiode bzw. interne Freilaufdiode bezeichnet wird. Der selbstsperrende n-Kanal-MOSFET 2 ist aus Silizium, wogegen der selbstsperrende n-Kanal-JFET 4 aus Siliziumcarbid besteht. Dieser Hybrid-Leistungs-MOSFET ist für eine hohe Sperrspannung von über 600 Volt ausgelegt und weist dennoch nur geringe Verluste im Durchlaßbereich auf.

Gesteuert wird diese bekannte Kaskodenschaltung mittels der Gate-Spannung U_{6' s}" des selbstsperrenden MOSFET 2. Ist der MOSFET 2 eingeschaltet oder die antiparallele interne Diode D_{IN} des MOSFET 2 führt einen Strom, so ist die Drain-Spannung U_{D'S'} des MOSFET 2 näherungsweise Null. Durch die Kopplung des Gate-Anschlusses des JFET 4 mit dem Source-Anschluß S' des MOSFET 2 ist die Gate-Spannung U_{GS} des JFET 4 Null bis ein wenig negativ oder positiv. Gemäß einer Übertragungskennlinie fließt durch den JFET 4 annähernd der größte Drain-Strom I_{D}. Wird der MOSFET 2 abgeschaltet, so steigt die Drain-Spannung U_{D'S'} an, bis die maximal zulässige Sperrspannung des MOSFET 2 erreicht ist. Der Wert der Sperrspannung ist bei einem Niedervolt-Leistungs-MOSFET 2 beispielsweise 30 Volt. Sobald der Wert der Drain-Spannung U_{D'S'} des MOSFET 2 den Wert der Schwellenspannung U_{Th} des JFET 4 überschreitet, ist der Drain-Strom I_{D} des JFET 4 gemäß seiner Übertragungskennlinie Null. Das heißt, der JFET 4 ist abgeschaltet. Durch die Verkopplung des Gate-Anschlusses G des JFET 4 mit dem Source-Anschluß S' des MOSFET 2 wird die Drain-Spannung U_{D'S'} des MOSFET 2 auf das Gate G des JFET 4 gegengekoppelt.

Der bekannte Hybrid-Leistungs-MOSFET ist grundsätzlich parallel schaltbar, wodurch die Stromtragfähigkeit der Gesamtanordnung erhöht wird. Die Nachteile einer derartigen konventionellen Parallelschaltung von n Kaskodenschaltungen sind wie folgt:
a) bei n parallelen Kaskodenschaltungen werden 2n Chips benötigt, wodurch die Aufbautechnik kompliziert wird.
b) bei n parallelen Kaskodenschaltungen werden n Steuerleitungen benötigt, wegen der Entkopplung der Gate-Anschlüsse der n MOSFET.

Aus der Veröffentlichung "A Novel MMIC Power Amplifier for Pocket-Size Cellular Telephones" abgedruckt in der Zeitschrift "IEEE MTS INTENATIONAL MICROWAVE SYMPOSIUM DIGEST", 1993, Seiten 793 bis 796 ist eine Kaskodenschaltung mehrerer FETs bekannt. Diese Kaskodenschaltung besteht aus einer Parallelschaltung von Kaskodenschaltungen eines Common Source FETs und eines Common Gate FETs. Bei der Kaskodenschaltung Common Source FETs sind die Source-Anschlüsse mehrerer FETs miteinander verknüpft, wogegen bei der Kaskodenschaltung Common Gate FETs die Gate-Anschlüsse mehrerer FETs miteinander verknüpft sind. Diese beiden Kaskodenschaltung sind derart miteinander verknüpft, dass der Drain-Anschluss der Common Sₒurce FETs mit dem Source-Anschluss der Common Gate FETs verknüpft sind. Somit erhält man einen sehr kompakten monolithischen Leistungs-FET für mobile Telefone.

Der Erfindung liegt nun die Aufgabe zugrunde, einen Hybrid-Leistungs-MOSFET für eine hohe Stromtragfähigkeit anzugeben, der die zuvor genannten Nachteile nicht mehr aufweist.

Diese Aufgabe wird erfindungsgemäß mit den Merkmalen des Anspruchs 1 gelöst.

Dadurch, daß zur Erhöhung der Stromtragfähigkeit des bekannten Hybrid-Leistungs-MOSFET nur ein niedersperrender MOSFET und wenigstens zwei hochsperrende Sperrschicht-FET, die elektrisch parallel geschaltet sind, verwendet werden, verringert sich die Anzahl der Chips bei einem Hybrid-Leistungs-MOSFET mit n hochsperrenden Sperrschicht-FET auf n+1 Chips. Außerdeₘ wird nur eine Steuerleitung benötigt, da nur ein niedersperrender MOSFET verwendet wird. Dieser MOSFET hat die Funktion eines Steuerkopfes. Ferner vereinfacht sich die Aufbautechnik dieses erfindungsgemäßen Hybrid-Leistungs-MOSFET für eine hohe Stromtragfähigkeit sehr, da anstelle von 2n Chips bei einer konventionellen Parallelschaltung nun nur noch n+1 Chips bei der Kaskodenschaltung verwendet werden.

Bei einer vorteilhaften Ausgestaltung des erfindungsgemäßen Hybrid-Leistungs-MOSFET ist in jeder Verbindungsleitung zwischen einem Gate-Anschluß der parallel geschalteten Sperrschicht-FET und einem Source-Anschluß des niedersperrenden MOSFET ein Gate-Widerstand angeordnet. Dadurch werden die Steuerkreise der Sperrschicht-FET voneinander entkoppelt und so das Schaltverhalten des Hybrid-Leistungs-MOSFET wesentlich verbessert.

Bei einer weiteren vorteilhaften Ausgestaltung des erfindungsgemäßen Hybrid-Leistungs-MOSFET ist in jeder Verbindungsleitung zwischen dem Drain-Anschluß des niedersperrenden MOSFET und einem Source-Anschluß der parallel geschalteten Sperrschicht-FET eine Induktivität angeordnet. Dadurch verbessert sich die Symmetrierung der dynamischen Stromabteilung des Hybrid-Leistungs-MOSFET.

Bei einer weiteren vorteilhaften Ausgestaltung weist jeder Sperrschicht-FET des erfindungsgemäßen Hybrid-Leistungs-MOSFET einen Gate-W-iderscand auf und in den Verbindungsleitungen des MOSFET mit den parallel geschalteten Sperrschicht-FET sind jeweils eine Induktivität angeordnet. Somit erhält man einen Hybrid-Leistungs-MOSFET, dessen Schaltverfahren und dessen Symmetrierung der dynamischen Stromaufteilung verbessert worden ist. Diese Ausführungsform ist insbesondere vorteilhaft, wenn als Induktivität jeweils ein verlängerter Bonddraht verwendet wird.

Weitere Ausgestaltungen des erfindungsgemäßen Hybrid-Leistungs-MOSFET sind den Unteransprüchen 5 bis 7 zu entnehmen.

Zur näheren Erläuterung der Erfindung wird auf die Zeichnung Bezug genommen, in der mehrere Ausführungsformen des erfindungsgemäßen Hybrid-Leistungs-MOSFET schewatisch veranschaulicht sind.
- FIG 1: zeigt die Schaltung eines bekannten Hybrid-Leistungs-MOSFET, die
- FIG 2: zeigt eine Schaltung eines erfindungsgemäßen Hybrid-Leistungs-MOSFET und in den
- FIG 3-5: sind vorteilhafte Ausführungsformen des erfindungsgemäßen Hybrid-Leistungs-MOSFET nach der FIG 2 dargestellt.

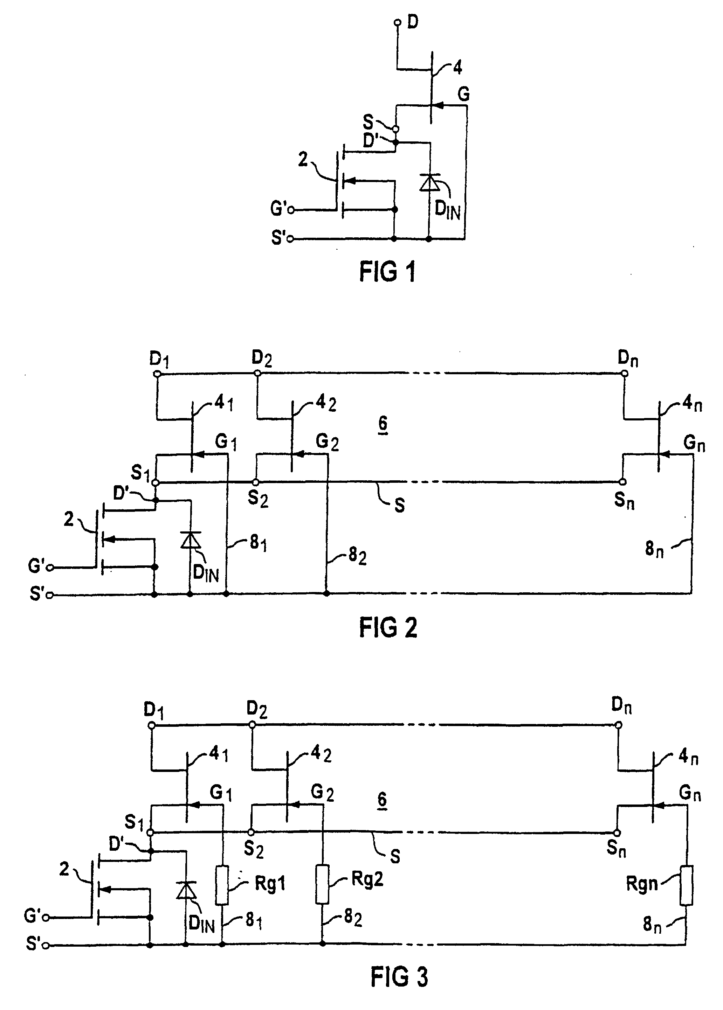

In der FIG 2 ist ein erfindungsgemäßer Hybrid-Leistungs-MOSFET näher dargestellt. Dieser Hybrid-Leistungs-MOSFET weist einen niedersperrenden MOSFET 2 und n hochsperrende Sperrschicht-FET 4₁ bis 4ₙ auf. Die Anzahl der verwendeten Sperrschicht-FET 4₁ bis 4ₙ hängt von der geforderten Stromtragfähigkeit des Hybrid-Leistungs-MOSFET ab. Diese n JFET 4₁ bis 4ₙ sind elektrisch parallel geschaltet. Der gemeinsame Source-Anschluß S dieser Parallelschaltung 6 ist mit dem Drain-Anschluß D' des niedersperrenden MOSFET 2 elektrisch leitend verbunden. Dieser MOSFET 2 hat die Funktion eines Steuerkopfes. Durch die Verwendung nur eines MOSFET 2 werden gegenüber einer konventionellen Parallelschaltung mehrerer bekannter Hybrid-Leistungs-MOSFET n-1 Steuerleitungen eingespart, wodurch sich der Aufbau dieser erfindungsgemäßen Kaskodenschaltung wesentlich verbessert. Die Gate-Anschlüsse G₁ bis Gₙ der parallel geschalteten JFET 4₁ bis 4ₙ sind mittels einer Verbindungsleitung 8₁ bis 8ₙ mit den Source-Anschluß S' des niedersperrenden MOSFET 2 verbunden. Wie bei dem bekannten Hybrid-Leistungs-MOSFET wird beim erfindungsgemäßen Hybrid-Leistungs-MOSFET als niedersperrender MOSFET 2 ein selbstsperrender n-Kanal Leistungs-MOSFET, insbesondere ein Niedervolt-Leistungs-MOSFET, verwendet, der aus Silizium besteht. Die verwendeten JFET 4₁ bis 4ₙ bestehen jeweils aus Siliziumcarbid.

Bei einer vorteilhaften Ausführungsform des erfindungsgemäßen Hybrid-Leistungs-MOSFET der FIG 3 sind in jeder Verbindungsleitung 8₁ bis 8ₙ der Parallelschaltung 6 gemäß den Gate-Widerständen Rgl bis Rgn angeordnet. Durch die Verwendung dieser Gate-Widerstände Rgl bis Rgn werden die Steuerkreise der JFET 4₁ bis 4ₙ voneinander entkoppelt. Dadurch verbessert sich das Schaltverhalten dieser erfindungsgemäßen Kaskodenschaltung wesentlich.

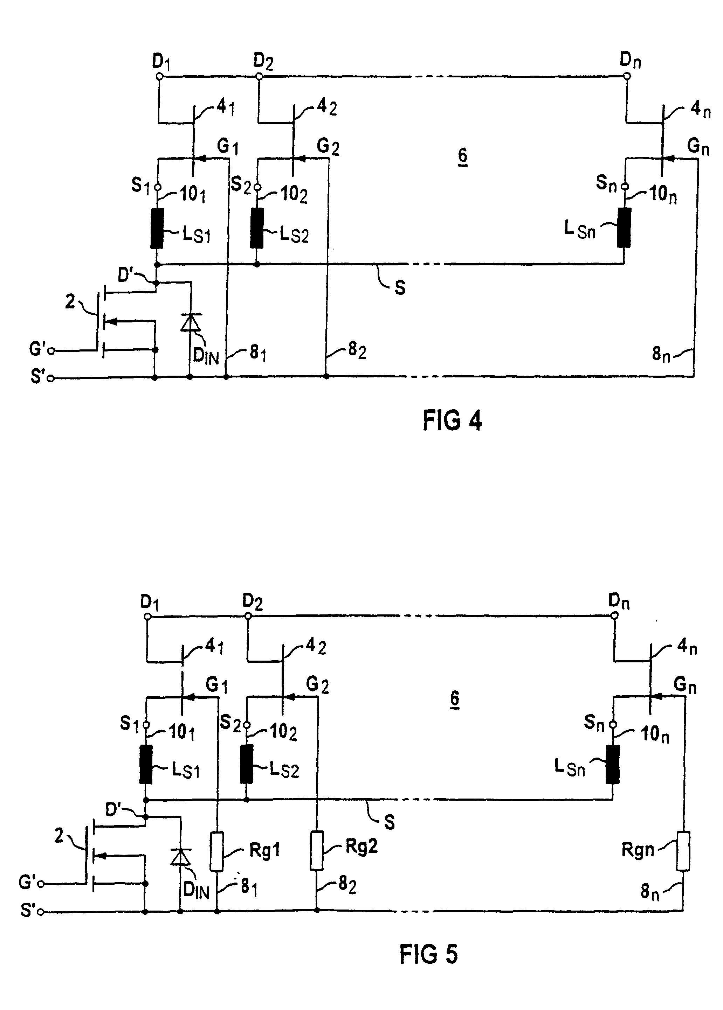

In der FIG 4 ist eine weitere vorteilhafte Ausführungsform des erfindungsgemäßen Hybrid-Leistungs-MOSFET nach FIG 2 näher dargestellt. Bei dieser Ausführungsform sind in den Verbindungsleitungen 10₁ bis 10ₙ zwischen den Source-Anschlüssen S₁ bis Sₙ und dem Drain-Anschluß D' des niedersperrenden MOSFET 2 jeweils eine Induktivität L_{S1} bis L_{Sn} angeordnet. Durch diese Induktivitäten L_{S1} bis L_{Sn} werden die Spannungsabfälle an diesen Induktivitäten L_{S1} bis L_{Sn} aufgrund von Stromänderungen auf die korrespondierenden Gatespannungen jeder einzelnen JFET 4₁ bis 4ₙ rückgekoppelt, so daß die Stromänderung in den einzelnen JFET 4₁ bis 4ₙ symmetriert werden. Dies ermöglicht eine ideal gleiche Strombelastung für alle JFET 4₁ bis 4ₙ. Da bereits kleine Werte der Induktivität L_{S1} bis Lₛₙ bei entsprechenden Stromsteilheicen zu merklichen Spannungsabfällen an den Induktivitäten L_{S1} bis Lₛₙ führen, kann der Wert dieser Induktivitäten L_{S1} bis Lₛₙ sehr klein sein. Dadurch können als Induktivitäten L_{S1} bis Lₛₙ jeweils ein verlängerter Bonddraht zwischen den Source-Anschlüssen S₁ bis Sₙ der parallel geschalteten JFET 4₁ bis 4ₙ und dem Drain-Anschluß D' des Hybrid-Leistungs-MOSFET 2 realisiert werden.

In der FIG 5 ist eine weitere vorteilhafte Ausführungsform des Hybrid-Leistungs-MOSFET nach FIG 2 veranschaulicht. Diese Ausführungsform kombiniert die Ausführungsform nach FIG 3 mit der Ausführungsform nach FIG 4. Somit erhält man eine Kaskodenschaltung, deren Symmetrierung der dynamischen Stromaufteilung und deren Schaltverhalten verbessert ist.

## Patentansprüche

1. Hybrid-Leistungs-MOSFET mit einem niedersperrenden MOSFET (2) und einem hochsperrenden Sperrschicht-FET (4₁), wobei ein Source-Anschluss (S) des hochsperrenden Sperrschicht-FET (4₁) mit einem Drain-Anschluss (D') des niedersperrenden MOSFET (2) und wobei ein Gate-Anschluss (G) des Sperrschicht-FET (4₁) mit einem Source-Anschluss (S') des MOSFET (2) elektrisch leitend verbunden sind, **dadurch gekennzeichnet, dass** wenigstens ein zweiter hochsperrender Sperrschicht-FET (4₂,...,4ₙ) elektrisch parallel zum ersten hochsperrenden Sperrschicht-FET (4₁) geschaltet ist, dass ein Drain-Anschluss (D') des niedersperrenden MOSFET (2) jeweils mit einem Source-Anschluss (S) der weiteren Sperrschicht-FET (4₂,...,4ₙ) verbunden ist, und dass die Gate-Anschlüsse (G₁,..., Gₙ) der weiteren Sperrschicht-FET (4₂,..., 4ₙ) jeweils mit dem Source-Anschluss (S') des MOSFET (2) elektrisch leitend verbunden sind.

2. Hybrid-Leistungs-MOSFET nach Anspruch 1,
**dadurch gekennzeichnet, dass** in jeder Verbindungsleitung (8_{1,}..., 8ₙ) zwischen einem Gate-Anschluss (G₁,..., Gₙ) der parallel geschalteten Sperrschicht-FET (4₁,...,4ₙ) und einem Source-Anschluss (S') des niedersperrenden MOSFET (2) ein Gate-Widerstand (Rg1,...,Rng) angeordnet ist.

3. Hybrid-Leistungs-MOSFET nach Anspruch 1 oder 2,
**dadurch gekennzeichnet, dass** in jeder Verbindungsleitung (101,...,10ₙ) zwischen dem Drain-Anschluss (D') des MOSFET (2) und einem Source-Anschluss (S₁,...,Sₙ) der parallel geschalteten Sperrschicht-FET (4₁,...,4ₙ) eine Induktivität (L_{S1},... ,L_{Sn}) angeordnet ist.

4. Hybrid-Leistungs-MOSFET nach Anspruch 3,
**dadurch gekennzeichnet, dass** als Induktivität (L_{S1},... ,L_{Sn}) jeweils ein verlängerter Bonddraht vorgesehen ist.

5. Hybrid-Leistungs-MOSFET nach einem der vorgenannten Ansprüche, **dadurch gekennzeichnet, dass** als niedersperrender MOSFET (2) ein Niedervolt-Leistungs-MOSFET vorgesehen ist.

6. Hybrid-Leistungs-MOSFET nach einem der vorgenannten Ansprüche, **dadurch gekennzeichnet, dass** der niedersperrende MOSFET (2) aus Silizium besteht.

7. Hybrid-Leistungs-MOSFET nach einem der Ansprüche 1 bis 5, **dadurch gekennzeichnet, dass** jeder hochsperrende Sperrschicht-FET (4₁,...,4ₙ) aus Siliziumcarbid besteht.

## Claims

1. A hybrid power MOSFET having a MOSFET (2) with low blocking capability and a junction FET (4₁) with high blocking capability, wherein a source connection (S) of the junction FET (4₁) with high blocking capability is electrically conductively connected to a drain connection (D') of the MOSFET (2) with low blocking capability, and wherein a gate connection (G) of the junction FET (4₁) is electrically conductively connected to a source connection (S") of the MOSFET (2), **characterised in that** at least a second junction FET (4₂,...,4ₙ) with high blocking capability is electrically connected in parallel to the first junction FET (4₁) with high blocking capability, that a drain connection (D') of the MOSFET (2) with low blocking capability is connected in each case to a source connection (S) of the further junction FET (4₂, ...,4ₙ), and that each of the gate connections (G1,...,Gn) of the further junction FETs (4₂,...,4ₙ) is electrically conductively connected to the source connection (S') of the MOSFET (2).

2. The hybrid power MOSFET according to Claim 1, **characterised in that** a gate resistor (Rg1,...,Rgn) is disposed in each connecting line (8₁, ... ,8ₙ) between a gate connection (G₁,...,Gₙ) of the parallel-connected junction FETs (4₁,...,4ₙ) and a source connection (S') of the MOSFET (2) with low blocking capability.

3. The hybrid power MOSFET according to claim 1 or 2 **characterised in that** an inductance (L_{S1},...,L_{Sn}) is disposed in each connecting line (10₁,...,10ₙ) between the drain connection (D') of the MOSFET (2) and a source connection (S₁,...,Sₙ) of the parallel-connected junction FETs (4₁,...,4ₙ).

4. The hybrid power MOSFET according to Claim 3, **characterised in that** an elongated bonding wire is provided as the inductance (L_{S1},..., L_{Sn}) in each case.

5. The hybrid power MOSFET according to one of the preceding claims, **characterised in that** a low-voltage power MOSFET is provided as the MOSFET (2) with low blocking capability.

6. The hybrid power MOSFET according to one of the preceding claims, **characterised in that** the MOSFET (2) with low blocking capability is made of silicon.

7. The hybrid power MOSFET according to one of the Claims 1 to 5, **characterised in that** each junction FET (4₁,...,4ₙ) with high blocking capability is made of silicon carbide.

## Revendications

1. MOSFET de puissance hybride comprenant un MOSFET (2) à blocage bas et un FET (4₁) à couche de blocage à blocage haut, une home (S) de source du FET (4₁) à couche de blocage à blocage haut étant reliée d'une manière conductrice de l'électricité à une borne (D') de drain du MOSFET (2) à blocage bas et une borne (G) de grille du FET (4₁) à couche de blocage étant reliée d'une manière conductrice de l'électricité à une home (S') de source du MOSFET (2), **caractérisé en ce qu'**au moins un deuxième FET (4₂, ..., 4ₙ) à couche de blocage à blocage haut est monté respectivement en parallèle au premier FET (4₁) à couche de blocage à blocage haut, **en ce qu'**une borne (D') de drain du MOSFET (2) à blocage bas est reliée respectivement à une home (S) de source de l'autre FET (4₂, ..., 4ₙ) à couche de blocage et **en ce que** les bornes (G₁, ..., Gₙ) de grille des autres FETs (4₂, ..., 4ₙ) à couche de blocage sont reliées respectivement à la borne (S') de source du MOSFET (2).

2. MOSFET de puissance hybride suivant la revendication 1,
**caractérisé en ce que** dans chaque ligne (8₁, ..., 8ₙ) de liaison entre une borne (G₁, ..., Gₙ) de grille du FET (4₁, ..., 4ₙ) à couche de blocage monté en parallèle et une borne (S') de source du MOSFET (2) à blocage bas est montée une résistance (Rg1, ..., Rng) de grille.

3. MOSFET de puissance hybride suivant la revendication 1 ou 2,
**caractérisé en ce que** dans chaque ligne (10₁, ..., 10ₙ) de liaison entre la borne (D) de drain du MOSFET (2) et une borne (S₁.....Sₙ ) de source des FET (4₁, ..., 4ₙ) à couche de blocage montés en parallèle est montée une inductance (L_{S1}, ..., L_{Sn}).

4. MOSFET de puissance hybride suivant la revendication 3,
**caractérisé en ce qu'**il est prévu comme inductance (L_{S1}, .... L_{Sn}) respectivement un fil de liaison prolongé.

5. MOSFET de puissance hybride suivant l'une des revendications précédentes, **caractérisé en ce qu'**il est prévu comme MOSFET (2) à blocage bas un MOSFET de puissance basse tension.

6. MOSFET de puissance hybride suivant l'une des revendications précédentes, **caractérisé en ce que** le MOSFET (2) à blocage bas est en silicium.

7. MOSFET de puissance hybride suivant l'une des revendications 1 à 5, **caractérisé en ce que** chaque FET (4₁, ..., 4ₙ) à couche de blocage à blocage haut est en carbure de silicium.
